Europäisches Patentamt

European Patent Office

Office européen des brevets

(19)

(11) Numéro de publication: **0 269 532**
**B1**

(12) **FASCICULE DE BREVET EUROPEEN**

(45) Date de publication du fascicule du brevet: **06.02.91**

(51) Int. Cl.⁵: **C 30 B 9/00, C 30 B 29/52**

(21) Numéro de dépôt: **87420301.1**

(22) Date de dépôt: **03.11.87**

(54) **Procédé d'obtention, par refroidissement d'alliages à l'état fondu, de cristaux de composés intermétalliques, notamment, de monocristaux isolés.**

(30) Priorité: **05.11.86 FR 8615774**

(43) Date de publication de la demande:
**01.06.88 Bulletin 88/22**

(45) Mention de la délivrance du brevet:
**06.02.91 Bulletin 91/06**

(84) Etats contractants désignés:
**AT BE CH DE ES GB GR IT LI LU NL SE**

(56) Documents cités:
**DE-B-1 222 018**

**JAPANESE JOURNAL OF APPLIED PHYSICS, vol. 21, supplément 21-1, 1982, pages 11-17, Tokyo, JP; M. AOKI et al.: "(Invited) solution growth of II-VI compounds"**

(73) Titulaire: **PECHINEY**
**23, rue Balzac**
**F-75008 Paris (FR)**

(72) Inventeur: **Lang, Jean-Marc**
**16, rue Boileau**
**F-38700 La Tronche (FR)**
Inventeur: **Dubost, Bruno**
**3, rue Casimir Brenier**
**F-38120 St Egreve (FR)**

(74) Mandataire: **Vanlaer, Marcel et al**
**PECHINEY 28, rue de Bonnel**
**F-69433 Lyon Cédex 3 (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

## Description

L'invention est relative à un procédé d'obtention, par refroidissement d'alliages à l'état fondu, de cristaux de composés intermétalliques et, notamment, de monocristaux isolés.

L'importance des composés intermétalliques, dans l'industrie des matériaux à haute performance, justifie l'intérêt de disposer de cristaux de dimensions suffisantes pour permettre la détermination de leurs propriétés chimiques, cristallographiques, mécaniques ou autres. Il en est de même pour certains composés, découverts récemment, qui donnent naissance à des cristaux aux caractéristiques exceptionnelles telles que, notamment, la présence d'un axe de symétrie quinaire et appelés quasi-cristaux.

Certes, l'homme de l'art connaît des méthodes de préparation de cristaux de composés intermétalliques par refroidissement d'alliages à l'état fondu, mais ceux-ci sont de taille réduite et peuvent être pollués, lors de leur élaboration, soit par l'apparition de phases eutectiques, soit dans le cas de composés à fusion non congruente par la formation intermédiaire d'au moins un autre composé intermétallique résultant de la décomposition du composé déjà formé.

Dans le cas du système Al-Cu-Li étudié par HARDY, HK et SILCOCK, JM dans J. Inst. Met. 24; 423—428 (1955), si on coule un alliage de composition atomique égale à celle de la phase $T_2$ qui présente des axes de symétrie, d'ordre 5 et de nature quasi-cristalline (cf SAINFORT, P., DUBOST, B. et DUBUS, A., C. R. Acad. Sc, 301, II, 689—692 (1985), on obtient la phase cubique $R—Al_5CuLi_3$ enrobée de phase $T_2$. C'est dans le but d'obtenir des composés intermétalliques sous la forme de cristaux gros, isolés et monophasés que la demanderesse a mis au point le procédé, objet de la présente invention.

Ce procédé, consistant à refroidir un alliage préalablement fondu complètement dans un creuset chauffé, est caractérisé en ce que l'on met en oeuvre un alliage de composition telle que la première phase qui cristallise corresponde au composé a obtenir, lorsque l'on atteint une température située dans l'intervalle liquidus-solidus de l'alliage, on brasse le liquide de façon cylique en le soumettant à un cyclage thermique, tout en faisant décroître sa température à une vitessse inférieure à 5°C par minute sans atteindre la température à laquelle apparaît une autre phase solide puis, on expulse le liquide résiduel rapidement du creuset avant qu'aucune autre cristallisation ne puisse se produire.

Ainsi, l'invention consiste d'abord à mettre en oeuvre un alliage que l'on place dans un creuset chauffé de manière à le liquéfier complètement. Cet alliage n'a pas forcément la composition du composé à obtenir mais, en tout cas, une composition telle que la première phase qui cristallise ait pour composition celle dudit composé. Cette composition est nécessairement différente de celle du composé intermétallique si ce dernier est à fusion non congruente.

La détermination des compositions convenables est facilitée par la connaissance des daigrammes d'équilibre liquide-solide. La composition étant choisie, l'alliage est fondu complètement dans un creuset puis, refroidi à sa périphérie jusqu'à atteindre la température de solidification commençante de l'alliage. A ce moment, des cristaux du composé à obtenir se déposant sur les parois du creuset et, tout en continuant à refroidir, on brasse alors le liquide de façon cyclique au moyen d'un agitateur quelconque en même temps que l'on effectue un cyclage thermique, c'est-à-dire que l'on fait varier la température de part et d'autre de la courbe de refroidissement correspondant à une diminution de 5°C par minute. On a en effet constaté expérimentalement que ce brassage et ce cyclage thermique ont pour effet d'homogénéiser le liquide tout en permettant le développement des gros cristaux.

De préférence, cette opération est effectuée en entourant le creuset d'une spire dans laquelle on envoie un courant électrique de manière à développer des impulsions électromagnétiques. Chaque impulsion s'accompange d'un mouvement du liquide et d'une élévation de température. Entre deux impulsions, le liquide redevient calme et continue à se refroidir.

De préférence, chaque impulsion a une durée de 10 secondes, et est séparée de la suivante par une durée supérieure.

L'invention comporte également une autre étape qui est déclenchée avant que n'apparaisse une phase solide autre que celle du composé à obtenir et qui consiste à expulser le liquide résiduel rapidement pour qu'aucune autre cristallisation ne se produire. Cette expulsion est facilitée si la quantité de liquide résiduel est comprise entre 20 et 80% par rapport à l'ensemble solide-liquide. Des fractions très faibles de liquide empêchant l'expulsion tandis que des fractions trop fortes ne produisent pas des cristaux suffisamment gros et nombreux.

Une vitesse d'expulsion convenable peut être obtenue, par exemple, en aspirant rapidement le liquide au moyen d'un tube ouvert à ses extrémités et plongeant partiellement dans le liquide et à l'extrémité libre duquel on relie, par exemple, une pompe à vide par l'intermédiaire d'un piège à liquide.

De préférence, l'invention fait appel à un moyen d'expulsion original consistant d'abord à remplir complètement le creuset avec l'alliage fondu et à y faire barboter un gaz soluble dans le liquide, à le fermer avec un couvercle et à le placer dans une enceinte étanche. Le refroidissement étant effectué sur l'ensemble des faces du creuset, les cristaux se développent simultanément tout autour du liquide pour former une croûte continue. On s'arrange cependent pour limiter le refroidissement du côté du couvercle de manière que la croûte soit plus mince en cet endroit.

Le processus de brassage et de cyclage thermique ayant été appliqué en cours de refroidissement au liquide ainsi confiné et la quantité de liquide résiduel étant comprise entre 20 et 80%, une dépression brutale est appliquée au récipient de sorte que le gaz dissous dans le liquide forme, à l'intérieur de la partie solidifiée, une bulle qui s'échappe brusquement par rupture de la croûte mince de cristaux et déplacement du couvercle en dégageant les dendrites de la phase en croissance. On forme ainsi des géodes du composé à obtenir.

Le gaz dissous doit avoir une solubilité élevée dans l'alliage et on choisit de préférence un gaz qui génère de l'hydrogène dans le liquide comme, par exemple, un gaz chargé d'humidité. La pression obtenue dans l'enceinte doit, de préférence, se situer en-dessous de $10^2$ Pa et doit être atteinte en moins de 2 minutes.

Dans ces conditions, on évite à la fois les phénomènes de décomposition peritectique liés aux composés à fusion non congruente, d'apparition de phases eutectiques et les pollutions qui s'y rattachent.

L'invention peut être illustrée à l'aide des exemples d'application suivant:

Un alliage de composition atomique $Al_{6,4}Cu_{0,9}Li_{2,7}$ a été fondu dans un creuset en graphite chauffé à 650°C en quantité telle qu'il remplisse complètement le creuset.

On a fait barboter de l'argon ayant un point de rosée de 10°C dans le liquide pendant 5 minutes. Puis, on a mis un couvercle sur le creuset et placé l'ensemble dans une enceinte étanche reliée à un système de pompage.

L'alliage a été refroidi de manière à franchir l'intervalle de température compris entre 620 et 570°C en 8 heures, tandis qu'on le soumettait à des impulsions électromagnétiques d'une durée de 10 secondes toutes les 30 secondes.

A la température de 570°C, le système de pompage a été mis en service et on a abaissé la pression de $10^5$ à $10^2$ Pa en 100 secondes.

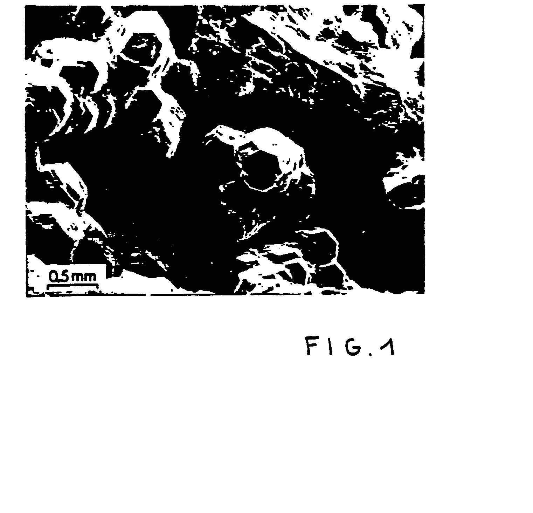

On a obtenu (des quasi-cristaux) monophasés du composé $T_2$—$Al_6CuLi_3$ ayant une morphologie triacontaédrique parfaitement facettée, des dimensions supérieures à 0,5 mm et dont les figures de diffraction électronique avaient une symétrie quinaire. La figure 1 est une photographie de ces (quasi-cristaux) dont aucune autre technique connue n'avait pu permettre de mettre en évidence la morphologie.

Au cours d'un autre essai effectué dans des conditions voisines, on a mis en oeuvre un alliage d'aluminium contenant en poids 29% de cuivre et 9,5% de lithium. On a obtenu des cristaux de la phase cubique R—$Al_5CuLi_3$ de taille centimétrique avec un facettage visible à l'oeil le long des plans [100] et [110].

Les composés obtenus sont généralement facettés, ce qui a pour avantage de permettre la caractéristation directe et aisée de leur microstructure ou de leurs propriétés en relation avec leur orientation cristalline souvent évidente pour l'homme de l'art. Ils peuvent notamment servir de germes à des expériences de croissance cristalline orientée ou cristallogenèse par solidification contrôlée de monocristaux de très grande taille en utilisant les techniques connues par l'homme de l'art. Un autre avantage de la présente invention est qu'elle permet d'isoler des monocristaux notamment de grandes dimensions (plusieurs dixièmes de millimètres à plusieurs centimètres) sans qu'il soit nécessaire de recourir à de longues et coûteuses étapes de recuit ou traitements thermiques d'homogénéisation (lesquelles sont généralement effectuées pour les alliages coulés avec la composition exacte du composé visé), ou encore à de délicates opérations de dissolution sélective de phases indésirables (par voie chimique ou électrochimique), ce qui altère généralement la surface des cristaux des composés étudiés.

## Revendications

1. Procédé d'obtention, par refroidissement d'alliages à l'état fondu, de cristaux de composés intermétalliques, notamment, de monocristaux isolés, dans lequel un alliage est préalablement fondu complètement dans un creuset chauffé, caractérisé en ce que l'on met en oeuvre un alliage de composition telle que la première phase qui cristallise corresponde au composé à obtenir, lorsque l'on atteint une température située dans l'intervalle liquidus-solidus du composé, on brasse le liquide de façon cyclique en le soumettant à un cyclage thermique tout en faisant décroître sa température à une vitesse inférieure à 5°C par minute sans atteindre la température à laquelle apparaît une autre phase solide puis, on expulse le liquide résiduel rapidement du creuset avant qu'aucune autre cristallisation ne puisse se produire.

2. Procédé selon la revendication 1 caractérisé en ce que le brassage et le cyclage thermique sont obtenus en développant des impulsions électromagnétiques dans le liquide.

3. Procédé selon la revendication 2 caractérisé en ce que chaque impulsion est séparée par un temps de repos supérieur à la durée de l'impulsion.

4. Procédé selon la revendication 3 caractérisé en ce que la durée de l'impulsion est de 10 secondes et le temps de repos de 20 secondes.

5. Procédé selon la revendication 1 caractérisé en ce que la quantité de liquide résiduel au moment de l'expulsion est de 20 à 80% par rapport à l'ensemble solide-liquide.

6. Procédé selon la revendication 1 caractérisé en ce que l'expulsion du liquide résiduel s'effectue par renversement du creuset.

7. Procédé selon la revendication 1 caractérisé en ce qu'on place le creuset dans une enceinte étanche, on le remplit complètement avec l'alliage fondu, on sature le liquide d'un gaz, on ferme le creuset avec un couvercle et assure le refroidissement de manière à former une mince croûte de cristaux au contact du couvercle et expulse le liquide par mise sous dépression brutale du récipient.

8. Procédé selon la revendication 7 caractérisé en ce que le gaz mis en oeuvre génère de l'hydrogène dans le liquide.

9. Procédé selon la revendication 7 caractérisé en ce que l'on abaisse la pression dans l'enceinte en-dessous de $10^2$ Pa en moins de 2 minutes.

10. Procédé selon la revendication 1 caractérisé en ce que l'expulsion du liquide résiduel est obtenue par immersion partielle dans le liquide d'un tube ouvert à ses deux extrémités et aspiration au niveau de l'extrémité non immergée.

11. Procédé selon les revendications 1 et 7 caractérisé en ce que la composition de l'alliage est différente de celle du composé visé.

12. Application du procédé selon la revendication 1 à l'obtention de composés à fusion non congruente.

13. Application du procédé selon la revendication 1 à l'obtention de (quasi-cristaux).

14. Application du procédé selon la revendication 13 à l'obtention de (quasi-cristaux) de composition atomique $Al_6 Cu Li_3$ de phase $T_2$ de morphologie triacontaédrique à partir d'un alliage à composition moins chargée en cuivre et en lithium que celle de la phase $T_2$.

15. Application du procédé selon la revendication 1 à l'obtention de cristaux de composition atomique $Al_5 Cu Li_3$ de phase cubique R.

**Patentansprüche**

1. Verfahren zur Herstellung von Kristallen intermetallischer Verbindungen, insbesondere einzelner Einkristalle, durch Abkühlen von Legierungen im geschmolzenen Zustand, bei dem eine Legierung vorab in einem geheizten Tiegel völlig geschmolzen wird, dadurch gekennzeichnet, daß man eine Legierung solcher Zusammensetzung einsetzt, daß die erste Phase, die kristallisiert, der herzustellenden Verbindung entspricht, wenn man eine im Liquidus-Solidus-Intervall der Verbindung liegende Temperatur erreicht, man die Schmelze in zyklischer Weise rührt, indem man sie einem Wärmezyklus unterwirft, bei dem man ihre Temperatur mit einer Geschwindigkeit unter 5°C je Minute ohne Erreichen der Temperatur sinken läßt, bei der eine andere feste Phase auftritt, und dann rasch die Restschmelze aus dem Tiegel entleert, bevor irgendeine weitere Kristallisation erfolgen kann.

2. Verfahren nach dem Anspruch 1, dadurch gekennzeichnet, daß das Rühren und der Wärmezyklus erzeugt werden, indem elektromagnetische Impulse in der Schmelze ausgelöst werden.

3. Verfahren nach dem Anspruch 2, dadurch gekennzeichnet, daß jeder Impuls durch eine Ruhezeit über der Dauer des Impulses getrennt ist.

4. Verfahren nach dem Anspruch 3, dadurch gekennzeichnet, daß die Dauer des Impulses 10 Sekunden und die Ruhezeil 20 Sekunden betragen.

5. Verfahren nach dem Anspruch 1, dadurch gekennzeichnet, daß die Restschmelzenmenge im Zeitpunkt der Entleerung 20 bis 80% bezüglich der Fest-Flüssig-Gesamtheit beträgt.

6. Verfahren nach dem Anspruch 1, dadurch gekennzeichnet, daß die Entleerung der Restschmelze durch Umkehren des Tiegels erfolgt.

7. Verfahren nach dem Anspruch 1, dadurch gekennzeichnet, daß man den Tiegel in ein dichtes Gehäuse einsetzt, ihn völlig mit der geschmolzenen Legierung füllt, die Schmelze mit einem Gas sättigt, den Tiegel mit einem Deckel schließt und die Abkühlung derart sichert, um eine dünne Kruste an Kristallen im Kontakt mit dem Dekkel zu bilden, und die Schmelze entleert, indem das Gehäuse unter plötzlichen Unterdruck gesetzt wird.

8. Verfahren nach dem Anspruch 7, dadurch gekennzeichnet, daß das verwendete Gas Wasserstoff in der Schmelze erzeugt.

9. Verfahren nach dem Anspruch 7, dadurch gekennzeichnet, daß man den Druck im Gehäuse in weniger als 2 Minuten unter $10^2$ Pa senkt.

10. Verfahren nach dem Anspruch 1, dadurch gekennzeichnet, daß die Entleerung der Restschmelze durch teilweises Eintauchen eines an seinen beiden Enden offenen Rohres in die Schmelze und Absaugen auf Höhe des nicht eingetauchten Endes erreicht wird.

11. Verfahren nach den Ansprüchen 1 und 7, dadurch gekennzeichnet, daß die Zusammensetzung der Legierung von der der angestrebten Verbindung verschieden ist.

12. Anwendung des Verfahrens nach dem Anspruch 1 zur Herstellung von Verbindungen mit nichtkongruentem Schmelzen.

13. Anwendung des Verfahrens nach dem Anspruch 1 zur Herstellung von (Quasi-Kristallen).

14. Anwendung des Verfahrens nach dem Anspruch 13 zur Herstellung von (Quasi-Kristallen) einer Atomzusammensetzung $Al_6CuLi_3$ mit $T_2$-Phase triacontaedrischer Morphologie aus einer Legierung einer weniger Kupfer und Lithium als die $T_2$-Phase enthaltenden Zusammensetzung.

15. Anwendung des Verfahrens nach dem Anspruch 1 zur Herstellung von Kristallen einer Atomzusammensetzung $Al_5CuLi_3$ kubischer R-Phase.

**Claims**

1. A process for obtaining crystals of intermetallic compounds, in particular isolated monocrystals, by cooling alloys in the molten state, in which an alloy is previously melted completely in a heated crucible, characterised by using an alloy of a composition such that the first phase to crystallise corresponds to the compound to be obtained, when a temperature in the liquidus-solidus range of the compound is attained, stirring the liquid cyclically and subjecting it to a thermal cycling effect while reducing its temperature at a rate of less than 5°C per minute without attaining the temperature at which another solid phase appears, and then rapidly expelling the residual liquid from the crucible before any other crystallisation can occur.

2. A process according to claim 1 characterised in that stirring and thermal cycling are effected by developing electromagnetic pulses in the liquid.

3. A process according to claim 2 characterised in that each pulse is separated by a phase which is greater than the duration of the pulse.

4. A process according to claim 3 characterised in that the duration of the pulse is 10 seconds and the pause is 20 seconds.

5. A process according to claim 1 characterised in that the amount of residual liquid at the time of expulsion is from 20 to 80% with respect to the solid-liquid assembly.

6. A process according to claim 1 characterised in that expulsion of the residual liquid is effected by turning the crucible over.

7. A process according to claim 1 characterised in that the crucible is placed in a sealed chamber, it is completely filled with the molten alloy, the liquid is saturated by a gas, the crucible is covered with a lid and cooling is effected in such a way as to form a thin crust of crystals in contact with the lid and the liquid is expelled by suddenly reducing the pressure of the container.

8. A process according to claim 7 characterised in that the gas used generates hydrogen in the liquid.

9. A process according to claim 7 characterised in that the pressure in the chamber is reduced below $10^2$ Pa in less than 2 minutes.

10. A process according to claim 1 characterised in that expulsion of the residual liquid is effected by partially immersing in the liquid a tube which is open at its two ends and producing a suction effect at the end which is not immersed.

11. A process according to claims 1 and 7 characterised in that the composition of the alloy is different from that of the desired compound.

12. Use of the process according to claim 1 for obtaining compounds which exhibit non-congruent melting.

13. Use of the process according to claim 1 for obtaining (quasi-crystals).

14. Use of the process according to claim 13 for obtaining (quasi-crystals) of the atomic composition $Al_6CuLi_3$ of phase $T_2$ of triacontahedric morphology from an alloy of a composition which is less charged with copper and lithium than that of phase $T_2$.

15. Use of the process according to claim 1 for obtaining crystals of an atomic composition $Al_5CuLi_3$ of cubic phase R.

0.5 mm

FIG.1